# EUROPEAN PATENT SPECIFICATION

(11) **EP 1 591 510 B1**
(45) Date of publication and mention of the grant of the patent: **21.05.2008**
(21) Application number: 05007241.2
(22) Date of filing: 02.04.2005
(51) Int. Cl.: C09K 11/06, C07D 209/86

(54) **Organic electroluminescence device**
Organische elektrolumineszente Vorrichtung mit einer Emitterschicht, die das Tetracarbazolbiphenyl enthält
Dispositif organique électroluminescent compronant une couche luminescente de tetracarbazolbiphenyl

(30) Priority: 09.04.2004 KR 2004024524
(43) Date of publication of application: 02.11.2005
(73) Proprietor: LG ELECTRONICS INC., Seoul (KR)
(72) Inventor: Seo, Jeong Dae, Yeounsu-gu Inchon (KR); Jeong, Hyun Cheol, Jinju-si Gyeongsangnam-do (KR); Park, Chun Gun, Gwanak-gu Seoul (KR); Lee, Kyung Hoon, Gangnam-gu Seoul (KR); Lee, Jae Man, Gangdong-gu Seoul (KR)
(74) Representative: TER MEER - STEINMEISTER & PARTNER GbR

(56) References cited:
- WO-A-20/04016711
- WO-A-20/04074399
- WO-A-20/05082851
- US-A1- 2002 034 656
- US-B1- 6 229 012

## Description

This application claims the benefit of the Korean Application No. 10-2004-0024524 filed on April 09, 2004, which is hereby incorporated by reference.

### BACKGROUND OF THE INVENTION

### Field of the Invention

The present invention relates to an organic electroluminescence device, and more particularly, to a blue phosphorescence organic electroluminescence device. An organic electroluminescence device according to the preamble of claim 1 is known from WO 2004/074399 A1.

### Discussion of the Related Art

Recently, the demand for a flat panel display device occupying less area is rising according to the tendency of manufacturing a wide-screen display device.

A technology for an organic electroluminescence device, which may be called an organic light emitting diode (OLED), as one of the flat panel display devices has been rapidly developed. And, various prototypes were already released.

The organic electroluminescence device is a device emitting light in a following manner. First of all, if electric charges are injected in an organic layer between a cathode and an anode, a pair of electron and hole is formed to disappear. While disappearing, the electron/hole pair emits light.

Hence, the organic electroluminescence device, which can be formed on a flexible transparent substrate like plastics, is drivable at a voltage (below 10V) lower than that of a plasma display panel (PDP) or an inorganic electroluminescence (EL) display.

The organic electroluminescence device needs relatively low power consumption and provides the excellent color sense.

In order to drive the organic electroluminescence device at low voltage, it is important to maintain very thin and uniform thickness (100~200am) of the organic layer and stability of the device.

In providing high efficiency to the organic electroluminescence device, it is important to sustain density balance between holes and electrons.

For instance, if an electron transport layer (ETL) is situated between an emitting layer (EML) and a cathode, most of the electrons injected in the emitting layer from the cathode move toward the anode to be recombined with holes.

Yet, if a hole transport layer (HTL) is inserted between the anode and the emitting layer, the electrons injected in the emitting layer are blocked by an interface of the hole transport layer. If so, the electrons are unable to further proceed to the anode but remains in the emitting layer only. Hence, recombination efficiency is enhanced.

A process of fabricating an organic EL device is explained as follows.

(1) First of all, an anode material is coated on a transparent substrate. ITO (indium tin oxide) is usually used as the anode material.

(2) A hole injection layer (HIL) is coated on the anode material. Copper phthalocyanine (CuPC) as the hole injection layer is mainly coated 10~30rum thick thereon.

(3) A hole transport layer (HTL) is introduced. (4,4'-bis[N-(1-naphthyl)-N-phenthylamino]-biphenyl(NPB) as the hole transport layer is deposited 30~60nm thick.

(4) An organic emitting layer is formed thereon. In doing so, a dopant is added thereto if necessary. In case of blue emission, 4,4,'-N,N-dicarbazolebiphenyl(CBP) as the organic emitting layer is deposited 30~60nm thick. And, bis(2-(4,6-difluorophenyl)pyridyl-N,C2')iridium(III) picolinate (named Firpic) is mainly used as the dopant.

(5) An electron transport layer (ETL) and an electron injection layer (EIL) are sequentially coated thereon or an electron injection transport layer is formed.

In case of blue emission, 4-biphenyloxolato aluminum(III)bis(2-methyl-8-quinolinato)4-phenylphenolate (named BAlq₃) having excellent electron injection/transport ability is usually used.

(6) A cathode is coated thereon. And, a protecting layer is finally formed thereon.

However, in the related art configuration, efficiency and performance of the organic electroluminescence device depend on what kind of host is used as the emitting layer.

### SUMMARY OF THE INVENTION

Accordingly, the present invention is directed to an organic electroluminescence device that substantially obviates one or more problems due to limitations and disadvantages of the related art.

An object of the present invention is to provide an organic electroluminescence device, by which high brightness is provided in a manner of using a host substance of an emitting layer.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, an organic electroluminescence device according to the present invention includes an anode, an organic emitting layer on the anode, and a cathode on the organic emitting layer, wherein the organic emitting layer has a configuration of Formula 1 and Formula 2,

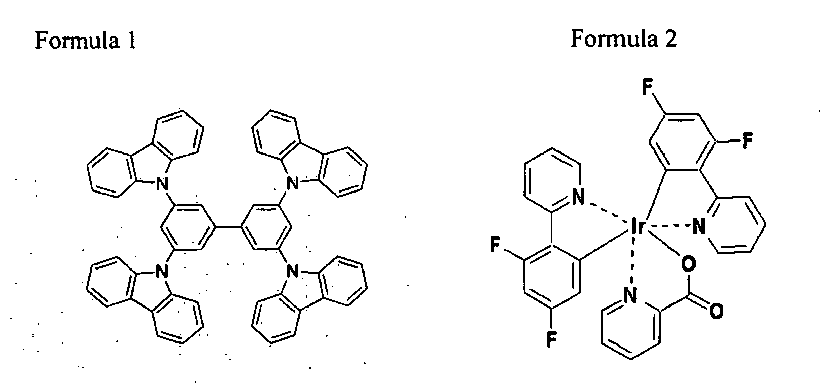

It is to be understood that both the foregoing general description and the following detailed description of the present invention are exemplary and explanatory and are intended to provide further explanation of the invention as claimed.

### BRIEF DESCRIPTION OF THE DRAWINGS

None

### DETAILED DESCRIPTION OF THE INVENTION

Reference will now be made in detail to the preferred embodiments of the present invention.

An organic electroluminescence device according to the present invention can be formed by sequentially stacking an anode, a hole injection layer, a hole transport layer, an organic emitting layer, an electron transport layer, an electron injection layer and a cathode.

In this case, the organic emitting layer can be formed of a host material having the configuration of Formula 1.

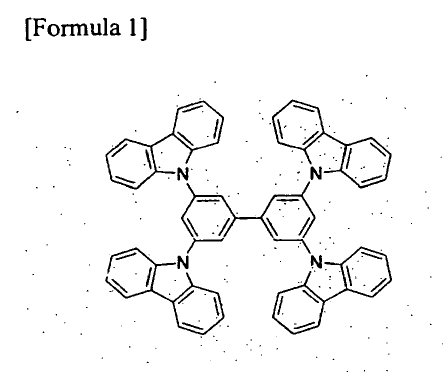

In Formula 1, the host material of Formula 1 is 3,3' ,5,5' - tetracarbazolbiphenyl (TCBP) that is synthesized in a following manner.

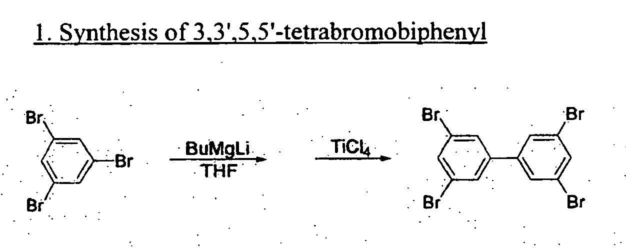

First of all, tributylmagnesiumchloride (8.73mL, 0.017mol) and anhydrous THF (50mL) are put in a dry round-bottom 2-neck flask and are then agitated. Subsequently, 2.5M n-BuLi (14.0mL, 0.035mol) is slowly dropped thereon and agitation is performed for 10 minutes at 10°C.

1,3,5-tribromobenzene (10g, 0.031mol) and anhydrous THF (50mL) are put in the flask to be agitated.

After the temperature is lowered to -40°C, tri-butylmagnesiurn lithium is slowly dropped in the flask to be agitated for 50 minutes.

After the temperature is lowered to -40°C again, titanium chloride (3.4g, 0.021mol) is injected using a syringe to be agitated for 2 hours at 0°C.

Once the reaction is terminated, the reactant solution is poured in an ammonium chloride solution (100mL) to be agitated for 30 minutes. Extraction is performed thereon with ethylacetate and washing is performed using distilled water (300mL).

After silica gel coating is performed, flash column is performed in hexane. And, recrystallization is carried out in ethyl alcohol to obtain 3,3',5,5'-tetrabromobiphenyl (4.0g, yield: 50%).

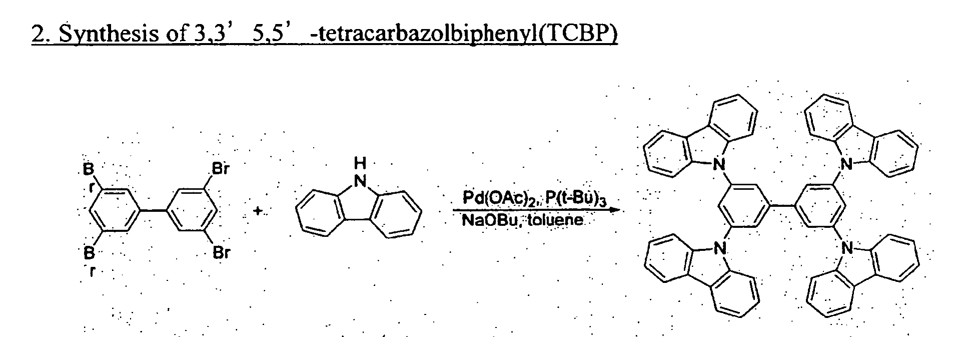

In a dry round-bottom 3-neck flask, 3,3',5,5'-tetrabromobiphenyl (2.0g, 4.3mol) and carbazol (5.8g, 34.4mol) are put is anhydrous toluene (50mL), and agitation is performed at room temperature for 30 minutes. Palladium acetate (0.11g, 0.5mmol), tri(t-butyl)phosphine (0.13g, 0.6mmol) and sodium-t-butoxide (6.14g, 0.064mol) are added thereto, and reflux is performed at 130°C for 12 hours.

After completion of reaction, toluene is removed by a rotating evaporator. Mixture is put in distilled water (200mL) to be agitated for 30 minutes. Precipitant is filtrated to be washed using hexane (200mL).

After silica gel coating is performed, flash column is performed in hexane: methylene chloride (3:1). Once precipitant is formed using petroleum ether after performing depressurization distillation on the solvent, filtration is performed to obtain 3,3' 5,5' - tetracarbazolbiphenyl(TCBP) (2.45g, yield: 70%).

An organic electroluminescence device according to a preferred embodiment of the present invention is explained as follows.

### Embodiment

An ITO (indium tin oxide) substrate (glass) is patterned to have an emitting size of 3mm x 3mm. And, a cleaning process is carried out on the patterned substrate.

Subsequently, after the substrate has been loaded in a vacuum chamber, basic pressure of 1x 10⁻⁶ torr is sustained therein. And, organic substance layers are formed on the ITO substrate in order of a hole injection layer (60Å), NPD (200A), TCBP+Firpic (8%) (200Å), BAlq₃ (100Å), Alq₃ (300Å), LiF (5Å) and Al (1,000Å).

If a current of 1mA is applied, 158cd/m² (8.09V) shows up. In this case, CIE (Commision Internationale de L' Eclairage) has x=0.202 and y=0.392.

NPD, Firpic, BAlq₃, and Alq₃ are shown in Formula 2.

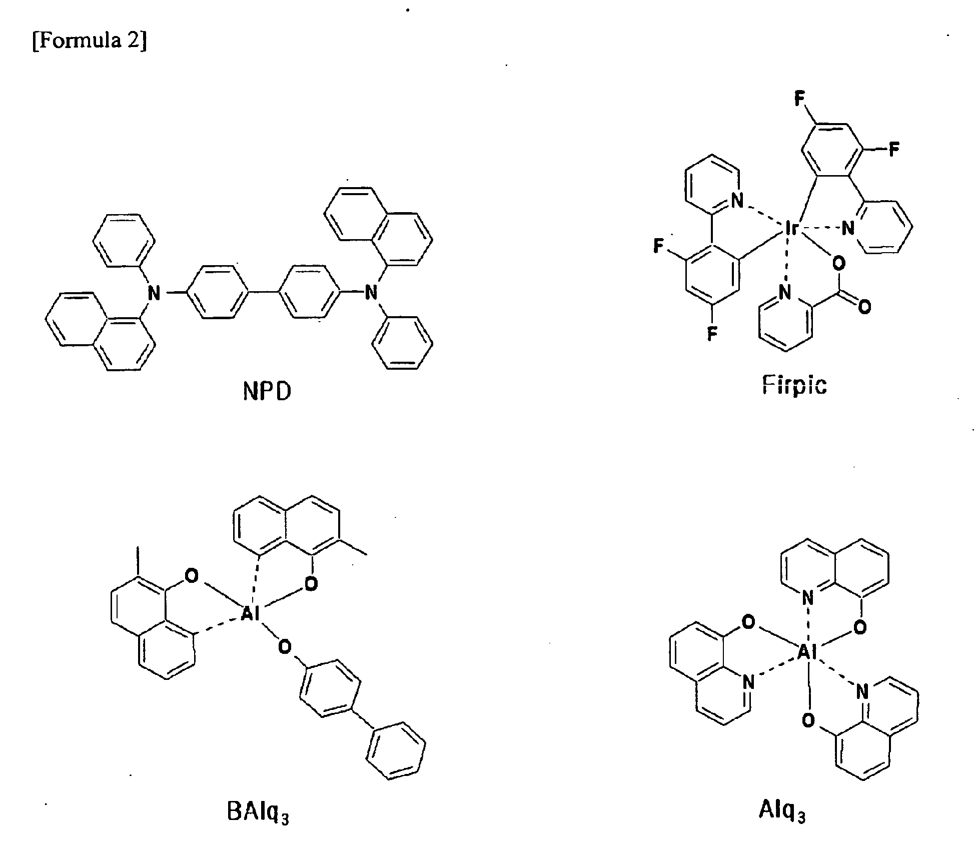

Accordingly, the organic electroluminescence device according to the present invention includes the organic emitting layer having the host and dopant materials between the cathode and the anode and forms the organic emitting layer using the host material in Formula 1, thereby obtaining the blue phosphorescence organic electroluminescence device of high brightness.

## Claims

1. An organic electroluminescence device comprising:
an anode;
an organic emitting layer on the anode; and
a cathode on the organic emitting layer,
**characterized in that** the organic emitting layer has a configuration of Formula 1and Formula 2,

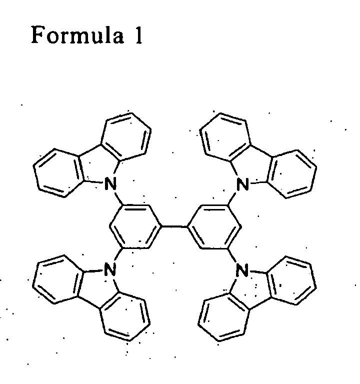

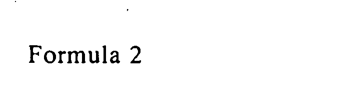

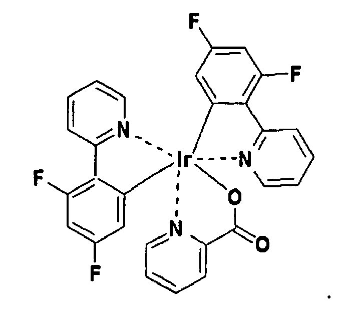

2. The organic electroluminescence device of claim 1, wherein the organic emitting layer further comprises Formula 3,

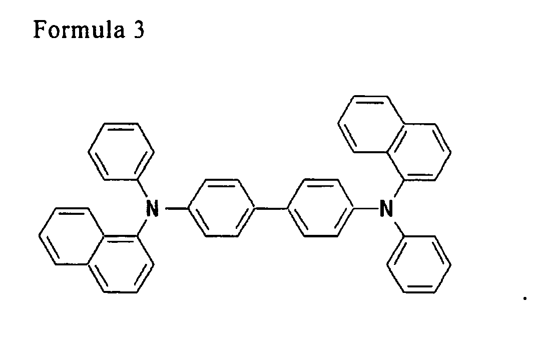

3. The organic electroluminescence device of claim 1, wherein the organic emitting layer further comprises Formula 4,

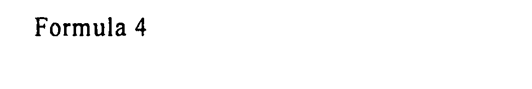

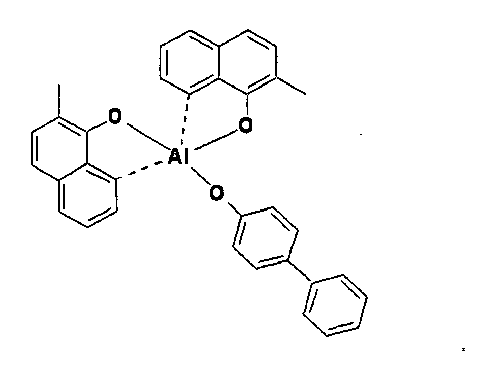

4. The organic electroluminescence device of claim 1, wherein the organic emitting layer further comprises Formula 5,

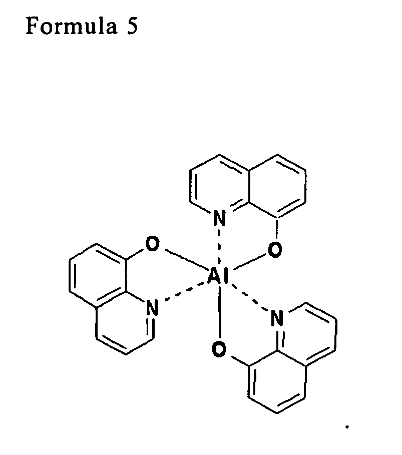

## Patentansprüche

1. Organische elektrolumineszente Vorrichtung, umfassend:
eine Anode;
eine organische emittierende Schicht auf der Anode; und
eine Kathode auf der organischen emittierenden Schicht,
**dadurch gekennzeichnet, dass** die organische emittierende Schicht eine Konfiguration aus Formel 1 und Formel 2 besitzt:

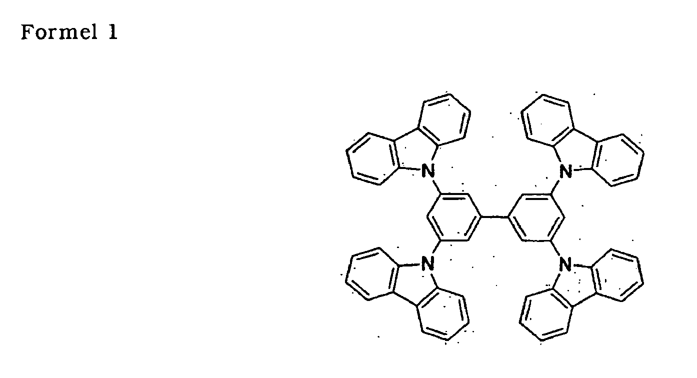

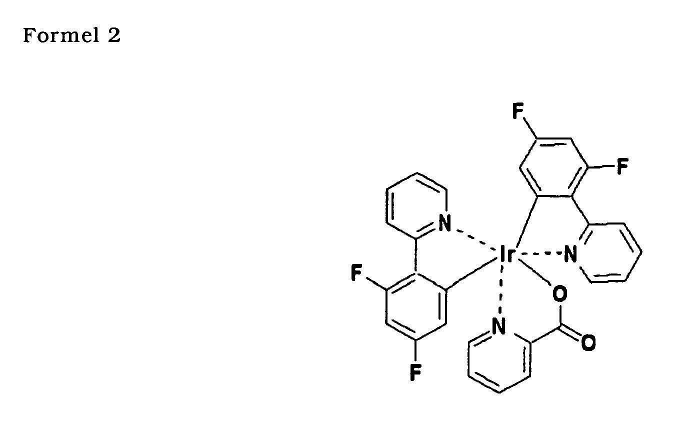

2. Organische elektrolumineszente Vorrichtung nach Anspruch 1, wobei die organische emittierende Schicht weiterhin Formel 3 umfasst:

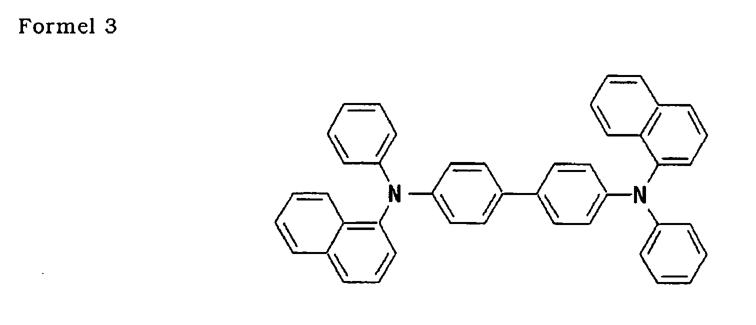

3. Organische elektrolumineszente Vorrichtung nach Anspruch 1, wobei die organische emittierende Schicht weiterhin Formel 4 umfasst:

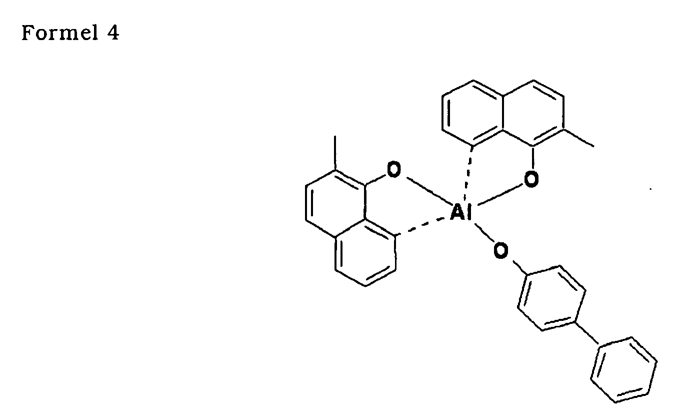

4. Organische elektrolumineszente Vorrichtung nach Anspruch 1, wobei die organische emittierende Schicht weiterhin Formel 5 umfasst:

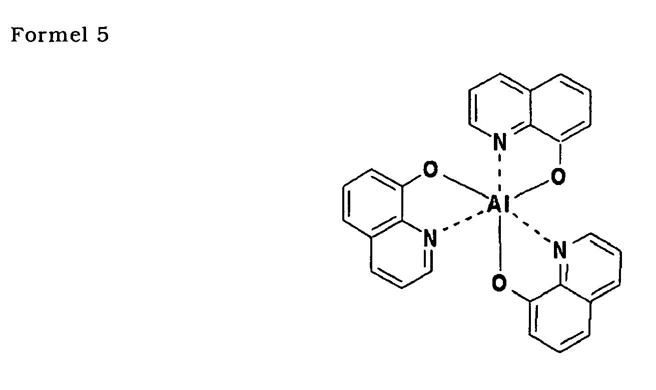

## Revendications

1. Un dispositif organique électroluminescent comprenant :
une anode ;
une couche organique émettrice sur l'anode ; et
une cathode sur la couche organique émettrice,
**caractérisé en ce que** la couche organique émettrice possède une configuration de formule 1 et de formule 2,

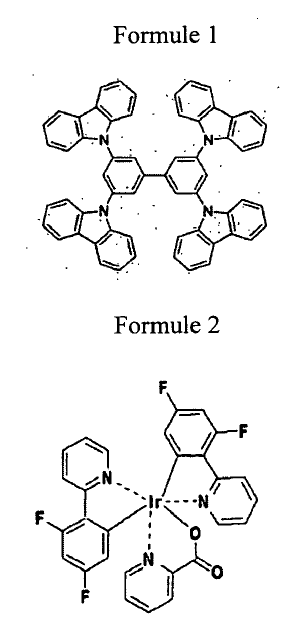

2. Le dispositif organique électroluminescent selon la revendication 1, dans lequel la couche organique émettrice comprend en outre la formule 3

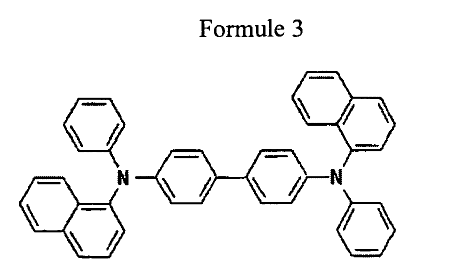

3. Le dispositif organique électroluminescent selon la revendication 1, dans lequel la couche organique émettrice comprend en outre la formule 4,

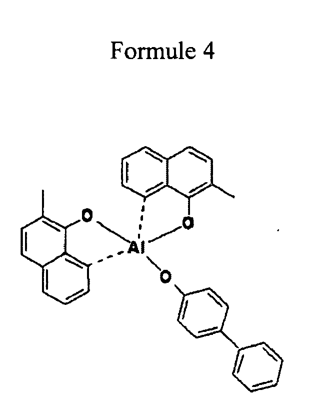

4. Le dispositif organique électroluminescent selon la revendication 1, dans lequel la couche organique émettrice comprend en outre la formule 5,
